# EUROPEAN PATENT APPLICATION

(11) **EP 1 011 111 A1**
(43) Date of publication of application: **21.06.2000**
(21) Application number: 99124541.6
(22) Date of filing: 23.02.1989
(51) Int. Cl.: H01C 7/00, H01C 17/16, H05K 1/16

(54) **Resistive metal layers and method for making same**

(30) Priority: 26.02.1988 US 160794; 26.02.1988 US 160795; 09.02.1989 US 307493
(62) Divisional of application: 89103215.3
(71) Applicant: Gould Electronics Inc., Eastlake, Ohio 44095-4001 (US)
(72) Inventor: Clouser, Sidney J., Chardon, Ohio 44024 (US); Lee, Chinho, Lyndhurst, Ohio 44124 (US); Prokop, Mary Katherine, Cleveland Heights, Ohio 44112 (US); Whewell, Christopher J., Willoughby, Ohio 44094 (US)
(74) Representative: Mallalieu, Catherine Louise

(57) **Abstract**

Electrodeposited planar resistive layers comprising nickel·sulfur and chromium·carbon·oxygen composites are provided. The planar resistors may be combined with conductive layers and insulative layers to produce laminates useful in the preparation of printed circuit boards. The resistive layers are prepared by electroplating from an electroplating bath containing a source of a normally conductive metal component and a source of a non-metallic resistance increasing additive such as oxygen, carbon and/or sulfur. The planar resistors have sheet resistances in the range of from about 15 to about 1000 Ω per square.

## Description

### Cross-References to Related Applications

This application is a continuation-in-part of co-pending applications, Serial Nos. 160,794 and 160,795, each filed on February 26, 1988 and assigned to the assignee of the present application.

### BACKGROUND OF THE INVENTION

### Field of the Invention

The invention of the present application relates to the field of precursor materials for printed circuit boards and to methods for making and using such materials. More particularly the invention relates to electrodeposited electrically resistive metal layers, to multiple layer foils which include such resistive layers and to laminates which include an insulative layer, an electrodeposited resistive metal layer and a conductive layer.

### The Prior Art Background

Since the pioneering inventions of Strong et al., disclosed in British Patent No. 690,691, published April 29, 1953, printed circuit board (PCB) technology has become an extremely important facet of the modern electronics industry. PCB technology has been facilitated by the development of cladding and related electrodeposition processes for producing thin foils for use as conductor materials. In an effort to minimize the space requirements on PCB components, the industry has turned to planar resistor technology, and in particular to electrodeposited resistive layers in an effort to increase circuit density, improve reliability and operating characteristics and reduce overall cost, especially by increasing manufacturing automation. These prior activities are summarized in an article of Mahler entitled "Planar Resistor Technology for High-speed Multilayer Boards", Electronic Packaging & Production, January, 1986, pp 151-154.

Important advances in the field of etchable electrodeposited layers of resistive materials have been made by Castonguay, as disclosed in the United States Letters Patent Nos. 3,857,683, by Castonguay et al., as disclosed in United States Letters Patent No. 3,808,576 and by Rice et al., as disclosed in International Application No. PCT/US86/01173, published as.International Publication No. WO 86/07100.

A large number of binary alloys are disclosed in U.S. 3,857,683 as being useful as resistive layers. However, most of these alloys have specific resistivities which are too low for practical commercial uses. Moreover, in many cases the ingredients necessary in the respective electroplating baths for producing the alloys are exotic and expensive and in some cases difficult and/or dangerous to handle. For example, in Examples XI and XXXI of the '683 patent, fluoborates of antimony and either cobalt or nickel and fluoboric acid are needed to prepare cobalt·antimony and nickel·antimony alloys respectively. Additionally, this prior publication provides no guidance whatsoever with regard to particular etchants or etching conditions which might be successfully employed to prepare printed circuits from a given binary alloy.

In any event, for one reason or another, and as illustrated in U.S. 3,808,576 and International Publication No. WO 86/07100, the nickel·phosphorous alloys have become the most widely used materials for PCB precursor resistive layer applications. In the 07100 International Publication, nickel·phosphorous resistance layers are plated onto copper foil from a plating bath free of sulfate and chloride salts. This reference specifically teaches that the use of such salts should be avoided because they cause embrittlement. Thus, the plating bath comprises nickel carbonate, phosphoric acid and phosphorous acid. In the '576 patent, the resistive layer includes up to 30% by weight phosphorous and the bath from which it is electrodeposited contains nickel sulfate hexahydrate, nickel chloride hexahydrate, nickel carbonate, phosphoric acid and phosphorous acid, as well as other additives. The use of so many reagents for forming the nickel·phosphorous layer, however, is technically cumbersome and tends to increase the cost of producing a commercially suitable resistive layer. Moreover, it is generally thought to be necessary to anodize the resistive alloy into oxides after the same has been electroplated onto a copper foil surface. This also results in added cost and inconvenience.

Thus, in spite of the advances in the art of providing electrodeposited planar resistance layers, those skilled in such art have continued to search for resistive materials which might be electrodeposited conveniently and reproducibly to provide a resistive layer which is readily etchable using safe etchants to provide printed circuit components having resistance lines and segments that have commercially appropriate and valuable resistance characteristics. The invention disclosed in the present application provides such resistive layers, components which incorporate such layers and methods and plating baths for making the same.

### SUMMARY OF THE INVENTION

The invention disclosed in this application provides a resistive layer for use in preparing printed circuit boards. The resistive layer comprises an electrodeposited layer of a composite of a normally conductive metal component and a resistance increasing amount of a non-metallic additive comprising at least one of carbon, oxygen and sulfur. In a preferred aspect of the invention, the metal component may comprise nickel and the non-metallic additive may comprise sulfur. In another preferred aspect of the invention, the metal component may comprise chromiun and the non-metallic additive may comprise oxygen and carbon. An important aim of the invention is to provide a resistive layer which has a nominal thickness of about 0.1 to about 0.4 microns (µ) and a sheet resistance of approximately 15 to 1000 ohms (Ω) per square.

The invention also provides a multiple layer foil for use in preparing printed circuit boards. The multiple layer foil of the invention comprises a conductive layer and a resistive layer as described and which may be electrodeposited on the conductive layer. Generally speaking, the conductive layer preferably may comprise an electrodeposited copper foil layer.

The invention further provides a laminate for use in preparing printed circuit boards. The laminate of the invention comprises an insulative layer and an electrodeposited resistive layer as described above and which is adhered thereto. In this aspect of the invention the laminate may also comprise a conductive layer adhered to the resistive layer. Again, the conductive layer preferably may comprise an electrodeposited copper foil layer.

Also provided by the invention is a printed circuit board comprising an insulative layer and a resistive line bonded to the insulative layer. The resistive line is composed of an electrodeposited material which comprises a composite of a normally conductive metal component and a resistance increasing amount of a non-metallic additive comprising at least one of carbon, oxygen and sulfur. The resistive line preferably has a sheet resistance of approximately 15 to 1000 Ω per square and in one important aspect of the invention may comprise nickel as the metal component and sulfur as the non-metallic additive. In another aspect of the invention, the resistive line may be such that the metal component comprises chromium and the non-metallic additive comprises oxygen and carbon. In this form of the invention, the printed circuit board may include means for electrically coupling an electrical potential to the resistive line. And preferably the electrically coupling means may comprise a pair of spaced copper pads adhered to the resistive line. Generally speaking, and in a preferred form of the invention, the resistive line and the spaced copper pads are characterized by having been created by etching respective electrodeposited layers.

The invention described herein also provides a method for electrodepositing a resistive layer. The method of the invention comprises the steps of providing a plating bath which contains an aqueous solution of a first source of a normally conductive metal component and a second source of a non-metallic resistance increasing additive comprising one or more of oxygen, carbon and sulfur. In accordance with the invention a conductive member is placed in the bath and then a resistive layer comprising a composite of the metal component and the resistance increasing additive is electroplated onto the conductive member by passing an electric current through the bath using the conductive member as a cathode. As before, in one aspect of the invention the electroplated resistive layer may include chromium as the normally conductive metal component and oxygen and carbon as the non-metallic resistance increasing additive. In another aspect of the invention, the electroplated resistance layer may comprise nickel as the normally conductive metal component and sulfur as the non-metallic resistance increasing additive. In instances where the resistive layer comprises oxygen and/or carbon as the non-metallic resistance increasing additive, the source thereof may comprise a water soluble organic acid or ionizable salt thereof. More particularly, such source may comprise formic acid, acetic acid or propionic acid or an alkali metal salt of such an acid. Preferably the source of oxygen and/or carbon may comprise propionic acid. When the method is utilized to electroplate a resistive layer comprising sulfur as a non-metallic resistance increasing additive, the source thereof may preferably comprise sodium thiosulfate.

In another important aspect, the invention provides a plating bath for electrodepositing a resistive layer comprising an aqueous solution of a first source of a normally conductive metal component and a second source of a non-metallic resistance increasing additive comprising one or more of oxygen, carbon and sulfur. In one form of the invention, the normally conductive metal component may be chromium and the non-metallic resistance increasing additive may comprise oxygen and carbon. In another form of the invention the normally conductive metal component may comprise nickel and the non-metallic resistance increasing additive may comprise sulfur. In those instances where the source of non-metallic resistance increasing additive provides oxygen and/or carbon, such source may comprise a water soluble organic acid or ionizable salt thereof. More particularly, such source may comprise formic acid or acetic acid, propionic acid or an alkali metal salt of such an acid. And in the preferred form of the invention, the source of oxygen and carbon may comprise propionic acid. In the form of the invention wherein the nonmetallic resistance increasing additive comprises sulfur, the source thereof may preferably comprise sodium thiosulfate.

More specifically, the plating bath provided by the invention may include a catalyst. In a preferred aspect of the invention, the catalyst may comprise oxy-halo anions such as periodate, iodate, perbromate, bromate, perchlorate or chlorate ions. The catalyst may also include sulfate ions. In the form of the invention wherein the normally conductive metal component is chromium, chromium trioxide may be utilized as a source of the chromium. In the form of the invention wherein the normally conductive metal component is nickel, nickel sulfate may be utilized as a source of the nickel.

In a further aspect of the invention, a method is provided for preparing a printed circuit board having at least one resistive line composed of a chromium composite and a conductive area on an insulative layer. In the method of this aspect of the invention, a laminate is provided having an insulative layer, a resistive chromium·carbon·oxygen resistive layer bonded to the insulative layer and a conductive copper foil layer affixed to the resistive chromium layer. The laminate is masked with a first mask and contacted with a first etchant which comprises cupric chloride whereby to remove the conductive copper layer from portions of the resistive chromium layer not covered by the first mask. The laminate is then contacted with a second etchant comprising hydrochloric acid to remove the resistive chromium layer from all portions of the insulative layer not covered by the first mask. The first mask is removed from the laminate and the laminate is masked with a second mask. The laminate masked with the second mask is then contacted with a third etchant comprising cupric chloride to remove the conductive copper foil layer from portions of the laminate not covered by the second mask while leaving behind the remaining resistive chromium layer to define at least one resistive chromium line and conductive copper areas on portions of the line. In this form of the invention, the second etchant is preferably 18% (by weight) hydrochloric acid and the same is maintained at a temperature of about 50°C during the etching process.

In another aspect of the invention, another method is provided for preparing a printed circuit board having at least one resistive line composed of a nickel composite and a conductive area on an insulative layer. In this form of the invention, a laminate is provided having an insulative layer, a resistive nickel·sulfur layer bonded to the insulative layer and a conductive copper foil affixed to the resistive nickel·sulfur layer. The laminate is masked with a first mask and is then contacted with a first etchant comprising cupric chloride to remove the conductive copper foil layer and the resistive nickel layer from all portions of the insulative layer not covered by the first mask. The masked laminate is then contacted with a second etchant comprising chromic acid and sulfuric acid to remove residues from unmasked portions of the insulative layer. The first mask is then removed from the laminate and a second mask is applied. The laminate masked with the second mask is then contacted with a third etchant comprising chromic acid and sulfuric acid to remove the conductive copper foil layer from all unmasked portions of the laminate while leaving behind the remaining resistive nickel·sulfur layer to define at least one resistive nickel·sulfur line on the insulative layer and conductive copper areas on portions of the resistive nickel line.

### BRIEF DESCRIPTION OF THE DRAWINGS

Figure 1 is a perspective view of a laminate embodying the invention of the present application and having as components thereof an insulative layer, a resistive layer adhered to the insulative layer and a conductive layer adhered to the resistive layer;
Figure 2 is a cross-sectional view taken alone the line 2-2 of Figure 1 to show the structural details of the laminate;
Figure 3 is a perspective view of the laminate of Figure 1 after a first etching step; and
Figure 4 is a perspective view of a printed circuit board prepared from the laminate of Figure 1 and which includes a resistive line and spaced copper pads providing means for electrically coupling an electrical potential to the line.

### DESCRIPTION OF THE PREFERRED EMBODIMENTS OF THE INVENTION

As set forth above, the invention described herein provides electrodeposited electrically resistive multiple layer foils which include an insulative layer, an electrodeposited resistive metal layer and a conductive layer. The invention also provides printed circuit boards prepared from such materials. Additionally, the invention provides a bath from which the resistive metal layers of the invention may be electrodeposited and a method for utilizing such a bath. Finally, the invention provides methodology for etching the laminates of the invention to prepare the printed circuit board components of the invention.

Generally speaking, the conductive layer may comprise any conductive material presently known to those of ordinary skill in the printed circuit board art, including copper, nickel, etc. However, the conductive layer utilized for purposes of the present invention preferably should be a plain electrodeposited copper foil which has been treated (stabilized) to prevent oxidation and which has otherwise been left untreated. Additionally, the invention has application irrespective of the manner in which the resistive layer and the conductive layer are attached to one another; however, in the preferred form of the invention, the resistive layer will be electrodeposited directly onto the matte side of the conductive layer. Thus, in its preferred form, the invention provides a novel printed circuit board material in the form of layered stock comprising at least one layer of an electrical resistance material adhered to and in intimate contact with a layer of a highly conductive material. The electrical resistance material comprises an electrodeposited layer of a composite of a normally conductive metal component and a resistance increasing amount of a non-metallic additive which may be carbon, oxygen or sulfur. Any normally conductive electrodepositable metal may be used as the metal component for the purposes of the invention. Preferably, however, the resistive layer will consist of an electrodeposited mixture of chromium, carbon and oxygen or an electrodeposited mixture of nickel and sulfur.

Various materials are known today from which printed circuit board components may be prepared. In general a printed circuit board material (or PCB precursor) consists of an insulating support and outer layers of a highly conductive material on one or both of the exterior surfaces of the support. The method of converting the precursor material into a desired product involves the selective removal of unwanted portions of the conductive layers to leave behind conductive areas of a desired configuration. The invention described herein pertains to the provision of an electrically resistive material (planar resistor) to be utilized in conjunction with a highly conductive layer. The highly conductive layer with the electrical resistance material physically adhered thereto may then be used for the production of printed circuit boards which include resistors as well as conductors. The methodology for the selective removal of unwanted areas from the highly conductive layer with the electrical resistance material physically adhered thereto is essentially the same as the methodology that has been utilized in the past for removing unwanted areas of conductive layers which are not joined to a resistance layer.

The resistive layer materials of the invention generally comprise an electrodeposited composite mixture of a normally conductive metal component and a resistance increasing amount of a non-metallic additive comprising at least one of carbon, oxygen and sulfur. The metal component may be any metal that is normally conductive and electrodepositable from an aqueous solution. However, nickel and chromium are preferred. The non-metallic additive may be any one or more of carbon, oxygen and sulfur. Preferably, the resistive material is an electrodeposited composite mixture of chromium, carbon and oxygen (chromium·carbon·oxygen) or an electrodeposited composite mixture of nickel and sulfur (nickel·sulfur). The preferred resistive layer may be further characterized as having a bulk resistivity greater than about 600 µΩ·cm (micro ohm·centimeters), as being plateable from aqueous solution to reproducibly yield an adherent deposit which is capable of being bonded to an insulative support without loss of physical integrity, as being non-radioactive, as having a melting point and crystallographic phase transitions, if any, at temperatures greater than about 450°F, as having a temperature coefficient of resistivity less than about 300 ppm/°C in the temperature range of from about 20°C to about 100°C when properly deposited, as having current versus voltage characteristics typical of presently available resistors, and as having sufficient chemical resistance to withstand normal use conditions when properly protected by passivation, anodization, overplating or coating with an organic or inorganic layer.

The resistive layer of the invention is deposited from an aqueous electroplating bath onto a conductive foil such as a stabilized copper foil layer. It is advantageous, although not necessary, at this point, to heat the thus prepared double layer foil at an elevated temperature in air or in a controlled atmosphere. The double foil layer then is ready to be laminated with its resistive layer against an insulative layer consisting of one or more plies of a fiberglass fabric which has been pre-impregnated with an appropriate formulation of curable organic resins. The multiple layer foil and the pre-impregnated fiberglass fabric (prepreg) are then bonded together utilizing conventional procedures involving pressing at 250 to 750 psi and 350 to 450°F for 40 minutes to 2 hours to present a laminate which consists of an insulative layer, an electrodeposited electrically resistive layer bound to the insulative layer and an outer conductive layer adhered to the resistive layer.

Following lamination, and at the time of use in printed circuit board manufacture, the copper surface may be coated with a photoresist material. The layer of photoresist may be conventionally exposed to a photographic negative containing the negative image of the combined resistor and conductor pattern. The exposed resist is developed and the unexposed portion is washed away. The laminate with the developed image or mask thereon is then etched in an etchant such as an alkaline etchant, ferric or cupric chloride acidified with hydrochloric acid or other suitable etchant, until the exposed bare copper has been removed. The laminate is then rinsed in water and immersed in an etchant, such as 18% (wt) aqueous hydrochloric acid at an elevated temperature, conventionally greater than 50°C, appropriate for removing the exposed bare resistive material. The remaining exposed photoresist may then be stripped off and the laminate coated with a new layer of photoresist. The laminate is again exposed through a photographic negative containing the negative image of the conductor pattern. The exposed resist is again developed and the unexposed portion washed away. The laminate with the developed image thereon is then etched once again to remove the exposed bare copper. Finally, the laminate is rinsed and dried. At this point the conductive and resistive areas are defined and are each in appropriate contact, one with the other to present a printed circuit board having a planar resistor.

While the foregoing generally describes the methodology for preparing printed circuit board components from laminates, such as the laminates of the present invention, other and different procedures may be required, depending on the characteristics of the particular layers to be etched away. For example, etching with two different etch formulations may be necessary to achieve a single removal step due to the formation of a residue resulting from application of a first etchant.

The resistive layers of the invention are electrodeposited layers of a composite of a normally conductive metal component and a resistance increasing amount of a non-metallic additive comprising at least one of carbon, oxygen and sulfur. One of the novel aspects of the invention is based on the fact that the additive comes from a source which initially is an ingredient of the plating bath. Thus, in addition to the other normal ingredients of the bath, the bath includes a source of the normally conductive metal component of the resistive layer and a source of a non-metallic resistance increasing additive comprising one or more of oxygen, carbon and sulfur. The source of the non-metallic additive generally will be a compound that is soluble in the aqueous medium of the bath and which is not decomposed by the other ingredients of the bath. On the other hand, the source should generally be subject to decomposition upon application of the electroplating current to the plating bath. Upon decomposition of the source, the carbon, oxygen and/or sulfur species are released from the source and incorporated into the electrodeposited mass.

In accordance with the invention, it has been found that organic acids and salts thereof are useful as sources of carbon and oxygen for the purposes of the present invention. In particular, acids such as formic acid, acetic acid and propionic acid and the alkali metal salts thereof have been found to be affective. A particularly preferred and effective source for carbon and oxygen in accordance with the principles and concepts of the invention is propionic acid. Sodium thiosulfate has been found to be a particularly effective and preferred source of sulfur when the latter element is to be used as a non-metallic resistance increasing additive.

One of the preferred resistive materials of the invention comprises a composite containing chromium as the normally conductive metal component and carbon and oxygen as the non-metallic additive. The electroplating bath for preparing a resistive layer from such a material should preferably contain from about 25 to about 450 grams per liter of chromic acid anhydride, from about 0.1 to about 2.35 grams per liter of sulfuric acid, from 0 to about 50 grams per liter of an oxy-halo acid anion and from about 20 to about 300 grams per liter of an organic, preferably aliphatic, acid. In a general sense the quantity of the organic acid simply needs to be sufficient to achieve the objective of the invention which is to provide a sufficient amount of carbon and/or oxygen additive in the resistive layer to produce the desired resistivity, and in accordance with the invention, resistivity varies with the amount of the additive. Thus, resistivity is generally reduced when the amount of the additive incorporated into the electrodeposited resistive layer is decreased. The amount of the additive in the electrodeposited resistive layer varies with the amount of the source thereof which is originally dissolved in the bath. Accordingly, the sheet resistance of the deposited resistive layer will vary with the amount of the organic acid in the electroplating bath (other conditions being equal). Due to the nature of the electroplating operation, the variance is not always direct and the exact relationship between the amount of the source acid in the bath and the resistivity of the electroplated resistive layer must generally be determined empirically.

Again speaking generally, the temperature of the plating bath should be maintained in the range of from about 5 to about 50°C during the electroplating operation. The current density should generally range from about 50 amps per square foot up to the maximum density obtainable with the equipment at hand. In this regard, the maximum current density is limited only by criteria which are well known to those of ordinary skill in the electroplating art.

The resistive layers produced in accordance with the invention need simply be of sufficient thickness to be dimensionally stable during storage and further processing and utilization as a printed circuit board component. Otherwise, the thickness is not a critical factor. In a general sense, however, the resistive layers of the invention will have thicknesses in the range of from about 0.1 to about 0.4 microns (µ). It should be appreciated by those of ordinary skill in the electroplating art, however, that electrodeposited layers and the like have rough surfaces such that specific numbers for thickness are actually average thicknesses.

Oxy-halo acid anions are the primary catalyst used in the electroplating bath to promote deposit of chromium. A synergistic effect is seen when oxy-halo ions are used in combination with sulfuric acid. Chlorate, bromate and iodate ions have been found to be effective and in this regard the iodate is more effective than the bromate, which, in turn is more effective than the chlorate. Peroxy ions such as periodate, perbromate and perchlorate are also effective for the purposes of the invention. Preferably the oxy-halo acid anion may be provided by using the sodium or potassium salt of chloric acid, that is either sodium or potassium chlorate, the main reason being the relative low cost and ease of availability of these materials. Functionally, oxy-halo acid anions are powerful oxidizers and similar catalytic effects have been noted with other powerful oxidizers, for example, the permanganate ion. The latter anion is not completely satisfactory, however, in that it tends to be source of manganese which ends up in the electrodeposited layer and changes its character.

As set forth above, the organic acid in the electroplating bath provides a source of carbon and oxygen for the resultant resistive layer. The oxygen and carbon atoms released from the acid upon decomposition as a result of the application of current end up in the lattice of the deposited layer to thereby decrease the conductivity, or conversely to increase the resistivity thereof. The impurities and defects in the crystal lattice of a material are usually considered to have the effect of decreasing the conductivity relative to that of the pure bulk material. In accordance with the invention, the resistive layer has an intrinsically smaller conductivity (or greater sheet resistance) than the metal component itself would have. The exact nature and/or form of the additive in the composite material is not completely understood and it could be that the additive in the composite is present in elemental form or as a compound. In this regard, the resistive composite materials of the invention contain the two components, that is the metallic component and the non-metallic additive and the resultant electrodeposited composite may be in the form of a solid solution, pure elements, interelemental compounds and/or mixtures thereof. The simple objective is to provide a material which has a bulk resistivity greater than about 600 µΩ·cm and which is electrodeposited in a layer having a thickness of about 0.1 to about 0.4 µ so as to provide sheet resistances in the range of from about 15 to about 1000 Ω per square and preferably about 25 Ω per square. Simply stated, the material produced in accordance with the invention may simply be referred to as a composite of the metallic and the non-metallic components and the same is not necessarily an alloy or a dispersion; however, the latter phases or states are possibly achieved. Because of the dimensional and physical characteristics of the resistive layer it is difficult to determine the exact chemistry thereof or even the ratio of the ingredients therein. Accordingly, the desired resistivity characteristics must generally be obtained empirically by varying the amounts of the components in the electroplating bath and measuring the resistance of the resultant electrodeposited layer.

The chromic acid anhydride (CrO₃) is the source of the normally conductive metal component, which in this case is chromium. Sulfuric acid provides a source of sulfate anion, a known catalyst for the deposition of chrome. In this regard, it should be noted that the organic acid which has as its principal purpose the provision of a source of carbon and oxygen, works also in combination with the sulfuric acid to catalyze the deposition process.

Proper control of process parameters, including solution temperature, current density, plating time and agitation is necessary in order to achieve high deposition efficiency. In this connection, temperatures below about 23°C and above about 34°C have been found to have an adverse affect on efficiency. The optimum temperature of the bath is thus in the range from about 25 to about 35°C. The current density is the measure of the total rate of the reactions taking place at the electrodes. Use of excessively high or low current densities is undesirable. High currents result in heating which makes process control more difficult. With low currents the deposition is less efficient due to hydrogen evolution. Optimum current densities range from about 75 to about 300 amps per square foot and differ from one bath formulation to another. Plating time is directly related to the thickness of the deposit. Longer plating times generally produce thicker deposits and therefore lower sheet resistances, while shorter plating times generally provide higher sheet resistances. The agitation of the bath during the electrodeposition process enhances mass transfer to raise the limits of operable currents and improve deposition efficiency.

In accordance with the invention, it is desirable that the electrodeposited resistive layer be as uniform as possible. In beaker cells with stationary electrodes, deposition efficiency and uniformity are sensitive to electrode configuration. Horizontal cells work well while the conventional vertical cells tend to yield poor uniformity. With regard to electrode gap, larger gaps lead to larger IR loss but contribute to better current distribution and therefore better deposit uniformity. In a 5 inch by 5 inch horizontal cell used in accordance with the present invention, a 2 inch gap has been extensively tested with good results. Flow conditions should be such that the operating current is no more than about 40% of the mass transfer limited current. Uniformity of the electrodeposited resistive layer is related to the roughness of the substrate upon which the deposit is made. In order to achieve good uniformity, substrates with a lesser degree of roughness are more desirable. The use of substrates with a lesser degree of roughness, however, may result in a double layer foil which has an insufficient peel strength. Thus, a compromise between uniformity and peel strength is necessary in the selection of the substrate.

All of the constituents of the bath must work in a harmonious fashion. The chromium resistive material may be produced from a bath which contains only an organic acid, chromic anhydride and sulfate ions. The resistive material may also be produced from baths which contain only oxy-halo anions, chromic anhydride and sulfuric acid, or baths containing only oxy-halo anions, chromic anhydride and the organic acid. The use of oxy-halo anions allows the bath to be more tolerant of increased sulfate levels, however. For example, when no oxy-halo anions are present, poor results are obtained when sulfate ions are present in excess of 0.5 grams per liter. When oxy-halo anions are present, however, sulfate ion levels in excess of 2.0 grams per liter still provide a very high efficiency for the deposition process. Of course, when operating the bath at high levels of oxy-halo anions, it must be recognized that the formation of explosive oxides of the halogens may be encountered. For this reason it is suggested that the oxy-halo anion levels should not be allowed to exceed 7 or 8 grams per liter.

In accordance with the concepts and principles of the invention, it has been determined that the sheet resistance of a chromium·oxygen·carbon resistor layer varies with the concentration of chromium acid anhydride and sulfuric acid in the bath. Sheet resistance also varies with solution temperature and current density during the electroplating operation. These effects are illustrated in the following Tables 1 through 5 which set forth results of tests conducted in systems containing chromic acid anhydride, sulfuric acid and acetic acid. The effects of individually varying the concentrations of chromic acid, acetic acid and sulfuric acid are illustrated in Tables 1, 2 and 3, respectively. Of these three solution ingredients, the sheet resistance of the electroplated layer is most sensitive to sulfuric acid concentration. Increasing the amount of sulfuric acid causes sheet resistance to decrease initially and to then increase after passing a region of minimum resistance, as shown in Table 3. Also shown in Table 3 are the accompanying changes in the chromium content of the chromium resistive layer. This indicates that decreases in sheet resistance are accompanied by increases in chromium content, and vice versa. The chromium content is highest in the layer having the lowest resistance, thus providing an indication of the point where deposition efficiency is higher. From Table 3 it can therefore be seen that the highest deposition efficiency occurs at the point where the sulfuric acid concentration is in the range of from about 200 to about 250 ppm. The sheet resistance of the electrodeposited resistive layer is not as sensitive to variation of the concentrations of the other ingredients. However, the effects of varying the concentrations of these ingredients are similar to the sulfuric acid effects in that a condition may be identified where sheet resistance is at its minimal level, and this occurs at about 275 grams per liter for the chromic acid and between about 140 and 170 grams per liter for the acetic acid.

**Table 1**

| **EFFECT OF VARYING CHROMIC ACID IN ELECTROPLATING BATE ON RESISTANCE OF CHROME RESISTOR LAYER** | | | |
|---|---|---|---|
| Solution Chemistry - | | CrO₃: | Varying |
| | | Acetic Acid: | 200 g/l |
| | | H₂SO₄: | 250 ppm |
| Solution Temperature: | | 27.5°C | |

| CrO₃(g/l) | C.D.* x Time | | Sheet Resistance (Ohm/Sq) |
|---|---|---|---|
| 200 | 300 ASF** x 120 Sec. | | 76.0 |
| 225 | 300 ASF** x 120 Sec. | | 50.5 |
| 250 | 300 ASF** x 120 Sec. | | 58.6 |
| 275 | 300 ASF** x 120 Sec. | | 45.7 |
| 300 | 300 ASF** x 120 Sec. | | 51.9 |
| 200 | 300 ASF x 140 Sec. | | 43.9 |
| 225 | 300 ASF x 140 Sec. | | 46.3 |
| 250 | 300 ASF x 140 Sec. | | 37.4 |
| 275 | 300 ASF x 140 Sec. | | 24.9 |
| 300 | 300 ASF x 140 Sec. | | 37.1 |

| | | | |
|---|---|---|---|
| * C.D. = current density | | | |
| ** ASF = Amperes per square foot | | | |

**Table 2**

| **EFFECT OF VARYING ACETIC ACID IN ELECTROPLATING BATE ON RESISTANCE OF CHROME RESISTOR LAYER** | | | |
|---|---|---|---|
| Solution Chemistry - | | CrO₃: | 275 g/l |
| | | Acetic Acid: | Varying |
| | | H₂SO₄: | 220 ppm |
| Solution Temperature: | | 30°C | |

| Acetic Acid (g/l) | C.D. x Time | | Sheet Resistance (Ohm/Sq) |
|---|---|---|---|
| 100 | 300 ASF x 135 Sec. | | 35.2 |
| 110 | 300 ASF x 135 Sec. | | 33.3 |
| 120 | 300 ASF x 135 Sec. | | 29.6 |
| 130 | 300 ASF x 135 Sec. | | 29.3 |
| 140 | 300 ASF x 135 Sec. | | 17.6 |
| 150 | 300 ASF x 135 Sec. | | 15.8 |
| 160 | 300 ASF x 135 Sec. | | 18.7 |
| 170 | 300 ASF x 135 Sec. | | 18.6 |
| 180 | 300 ASF x 135 Sec. | | 22.4 |
| 190 | 300 ASF x 135 Sec. | | 20.8 |
| 200 | 300 ASF x 135 Sec. | | 22.4 |
| 210 | 300 ASF x 135 Sec. | | 26.8 |
| 220 | 300 ASF x 135 Sec. | | 43.5 |
| 230 | 300 ASF x 135 Sec. | | 42.3 |

**Table 3**

| **EFFECT OF VARYING H**_{**2**}**SO**_{**4**} **IN ELECTROPLATING BATH ON RESISTANCE OF CHROME RESISTOR LAYER** | | | | |
|---|---|---|---|---|
| Solution Chemistry - | | CrO₃: | | 247.5 g/l |
| | | Acetic Acid: | | 211.5 g/l |
| | | H₂SO₄: | | Varying |
| Solution Temperature: | | 28°C | | |

| H₂SO₄ (ppm) | C.D. x Time | | Sheet Resistance (Ohm/Sq) | Chrome Content (mg/dm²)*** |
|---|---|---|---|---|
| 0 | 300 ASF x 160 Sec. | | 54.9 | 12.0 |
| 75 | 300 ASF x 150 Sec. | | 52.5 | 14.1 |
| 100 | 300 ASF x 150 Sec. | | 35.5 | 16.2 |
| 150 | 300 ASF x 150 Sec. | | 29.4 | 20.0 |
| 200 | 300 ASF x 150 Sec. | | 25.1 | 19.4 |
| 250 | 300 ASF x 150 Sec. | | 26.4 | 19.4 |
| 300 | 300 ASF x 150 Sec. | | 34.0 | 19.7 |
| 400 | 300 ASF x 150 Sec. | | 78.5 | 18.3 |
| 500 | 300 ASF x 150 Sec. | | 152 | 16.0 |

| | | | | |
|---|---|---|---|---|
| ** mg/dm² = milligrams per square decimeter | | | | |

Table 4 set forth below illustrates the fact that the preferred solution temperature range is from about 28 to about 33°C. Sheet resistances tend to be higher at temperatures below and above the preferred range. This Table indicates that temperatures in the range of from about 28 to 48°C can be employed to produce a desired sheet resistance simply by adjusting the plating times.

**Table 4**

| **EFFECT OF VARYING ELECTROPLATING BATH TEMPERATURE ON RESISTANCE OF CHROME RESISTOR LAYER** | | | | |
|---|---|---|---|---|
| Solution | CrO₃ (g/l) | Acetic Acid (g/l) | H₂SO₄ (ppm) | |
| 1 | 247.5 | 211 | 200 | |
| 2 | 272 | 200 | 236 | |

| Solution Temp. (°C) | Solution | C.D. x Time | | Sheet Resistance (Ohm/Sq) |
|---|---|---|---|---|
| 28 | 1 | 300 ASF x 160 Sec. | | 54.9 |
| 38 | 1 | 300 ASF x 160 Sec. | | 49.7 |
| 48 | 1 | 300 ASF x 160 Sec. | | 135 |
| 21.5 | 2 | 300 ASF x 140 sec. | | 35.8 |
| 25 | 2 | 300 ASF x 140 sec. | | 31.3 |
| 28 | 2 | 300 ASF x 140 sec. | | 22.4 |
| 29 | 2 | 300 ASF x 140 sec. | | 22.4 |
| 33 | 2 | 300 ASF x 140 sec. | | 21.5 |
| 36.5 | 2 | 300 ASF x 140 sec. | | 30.7 |

Table 5 illustrates that the sheet resistance of the deposited resistive layer is significantly lower with a current density of 300 amps per square foot than with a current density of 600 amps per square foot.

**Table 5**

| **EFFECT OF VARYING ELECTROPLATING CURRENT DENSITY ON RESISTANCE OF CHROME RESISTOR LAYER** | | |
|---|---|---|
| Solution Chemistry - | CrO₃: | 247.5 g/l |
| | Acetic Acid: | 211 g/l |
| | H₂SO₄: | 250 ppm |
| Solution Temperature: | 28°C | |

| C.D. x Time | Charge Density (Coul/Ft²) | Sheet Resistance (Ohm/Sq) |
|---|---|---|
| 300 ASF x 200 Sec. | 60,000 | 10.5 |
| 600 ASF x 100 Sec. | 60,000 | 62.3 |
| 300 ASF x 240 Sec. | 72,000 | 8.5 |
| 600 ASF x 120 Sec. | 72,000 | 45.5 |
| 300 ASF x 280 Sec. | 84,000 | 7.0 |
| 600 ASF x 140 Sec. | 84,000 | 34.8 |

The deposition of chromium is promoted when sodium chlorate is added to a resistive chrome electroplating bath containing 300 grams per liter CrO₃, 200 grams per liter acetic acid and 100 ppm sulfuric acid. The presence of sodium chlorate in the bath results in lower sheet resistances as shown in Table 6. In generating the data set forth in Table 6 the current density was 300 amps/sq. ft., the bath temperature was 30°C, and the plating time was 45 seconds in each case. It is believed that the presence of the chlorate simply results in an increase in the deposition rate of the chromium. When chlorates and other oxyhalides are used in the plating bath the electroplating operation is more efficient and more easily controlled.

**Table 6**

| **EFFECT OF VARYING SODIUM CHLORATE IN ELECTROPLATING BATH ON RESISTANCE OF CHROME RESISTOR LAYER** | |
|---|---|
| NaClO₃ in bath (g/l) | Sheet Resistance (Ω/sq.) |
| 0.4 | 163.2 |
| 0.5 | 80.1 |
| 0.6 | 38.4 |
| 0.75 | 17.5 |
| 1.0 | 10.7 |
| 1.5 | 7.7 |
| 2.5 | 5.9 |

Acetic acid is used as the organic acid in the experiments used to develop the data for the foregoing tables. However, it has been determined that propionic acid may be the best presently known material for use as a source of carbon and oxygen in the chromium resistive layer. Thus, a bath was prepared to contain 300 grams per liter CrO₃, 15 ml per liter of propionic acid, and 3 grams per liter of sodium chlorate. The plating conditions were a bath temperature of 22°C; a current density of 75 amps per square foot; and a plating time of 45 seconds. The resistive layer thus produced had a sheet resistance of 25 Ω per square.

At the present time, three different plating bath formulations have been determined to provide consistent results. The bath chemistries and modes of operation are set forth in the following Table 7. The plating operations were conducted in a horizontal beaker cell and in each case a sheet resistance of 25 Ω per square was achieved.

**Table 7**

| **PREFERRED ELECTROPLATING BATH FORMULATIONS AND MODES OF OPERATION** | | | |
|---|---|---|---|
| | **Formulations** | | |
| | **I** | **II** | **III** |
| CrO₃ (g/l) | 300 | 300 | 300 |
| H₂SO₄ (g/l) | .2 - .3 | .2 - .3 | .2 - .3 |
| Sodium Chlorate (g/l) | - | 2.5 | 3.0 |
| Acetic Acid (g/l) | 150 | 150 | - |
| Propionic Acid (ml/l) | - | - | 40 |
| Solution Temperature (°C) | 28-30 | 28-30 | 28-30 |
| Current Density (ASF) | 300 | 300 | 75 |
| Plating Time (seconds) | 100 | 25-30 | 44 |
| Electrode Gap (inches) | 2 | 2 | 2 |
| Substrate | LP-P&S | LP-P&S | LP-P&S* |
| Agitation | None | None | None |

| | | | |
|---|---|---|---|
| * This designation refers to low profile (LP) copper foil which has a thickness of about 35 µ and an average roughness of less than about 1 µ and which is plain (untreated other than stabilization) and stabilized (P&S). | | | |

In the above table, formulation III is preferred simply because with it the current density may be low. The result of each plating operation is a multiple layer foil that comprises an electrodeposited resistive chromium layer having a thickness of about 0.25 to about 0.35 µ and a conductive copper layer having a thickness of about 35 µ. In accordance with the invention the copper substrate is used as the cathode in the process and the resistive chromium layer is electrodeposited directly onto the matte side of the plain and stabilized copper foil.

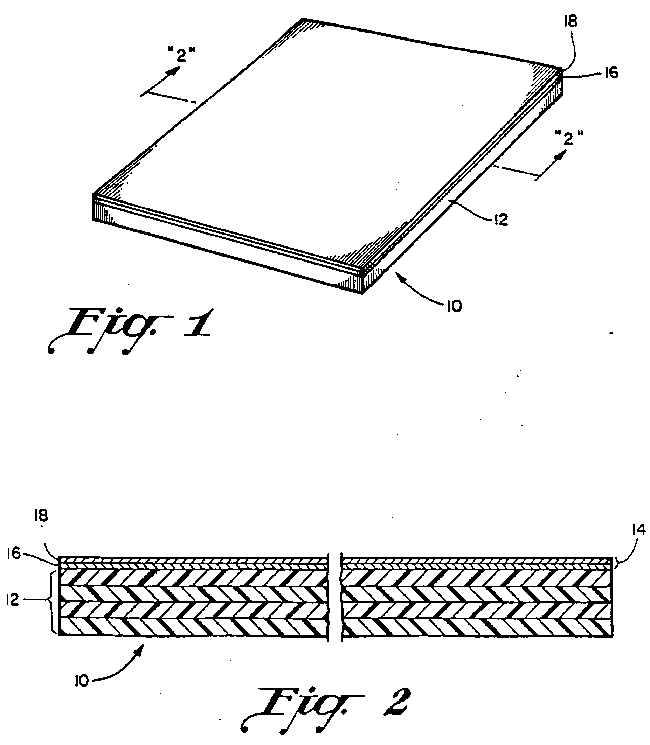

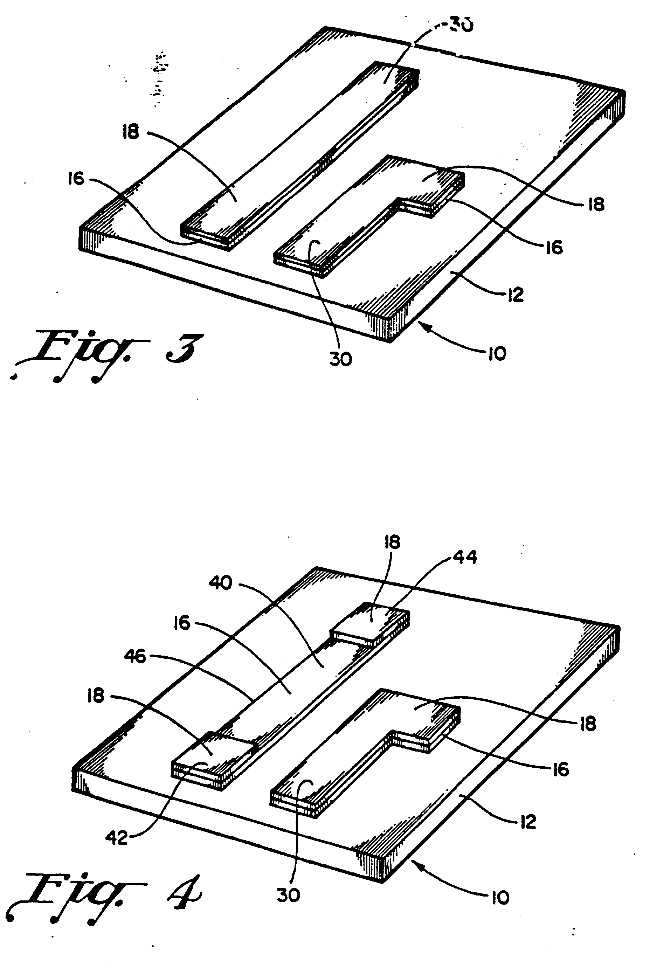

A multiple layer foil produced using plating bath formulation III chemistry and operating conditions as set forth in Table 7 was then bonded, with the copper conductive layer out, to a prepreg consisting of plurality of woven glass layers coated initially with a partially cured epoxy liquid resin. Such prepregs are well known to those skilled in the art and are readily available commercially. The bonding operation consists simply of the application of heat and pressure to the structure and the result is a laminate 10 as illustrated in Figures 1 and 2, where the multiple layer foil is identified by the reference numeral 14, the copper conductive foil layer is identified by the reference numeral 18, the resistive chromium layer is identified by the reference numeral 16 and an insulative layer produced by the application of heat and pressure to the prepreg is identified by the reference numeral 12. It should be appreciated that the thicknesses of the various layers shown in the drawings are not necessarily to scale.

The resistive layer of the invention may be utilized in conjunction with any conductive foil known to those skilled in the printed circuit board industry. For example, the resistive layer may be electrodeposited upon either treated or untreated copper foils. In this connection it should be noted that the resistive layer should generally be applied to the matte side of an electrodeposited conductive foil and in a practical sense the copper foil should be one which has been treated (stabilized) to prevent oxidation. But it should be recognized that in some instances it might be more desirable to apply the resistive layer to an untreated copper foil or one which has been fully bond-treated. Other conductive foils which might find application in connection with the present invention include rolled copper and electrodeposited nickel foils, for example.

Also it should be recognized that the insulative layer need not necessarily be a prepreg as discussed above. In this regard it has been found that a multiple layer foil which includes a resistive layer, such as the foil 14 described above, may be bonded to an adhesive coated polyester film. Using a lamination temperature of 300°F, pressures ranging from 40 to 300 psi and press times ranging from 10 to 90 seconds, laminates having peel strengths greater than 9.5 pounds per inch have been produced using a polyester film insulative layer.

The resistive layers produced in accordance with the invention described herein are characterized by excellent thermal and aging stability. The chromium resistive layers are generally characterized by a temperature coefficient of resistance below about 300 ppm/°C in the 20°C to 100°C temperature range. That is to say, for sheet resistances of about 25 Ω per square, the sheet resistance in the stated temperature range will increase about .0075 Ω per square for each degree Centigrade of temperature increase.

With regard to aging stability, storage in ambient air for 26 weeks, storage in an atmosphere of 70% relative humidity and 40°C for 18 hours, or exposure to air at 125°C for 4 hours all result in a net change of less than 1.5% for the chromium composite sheet resistances.

A multiple layer laminate such as the laminate 10 of Figures 1 and 2 and having a chromium resistive layer 16 may be used to prepare a printed circuit board. Using conventional procedures, a conductive line defining photoresist may be applied to the upper surface of the copper conductive layer 18 of the laminate 10. The photoresist may then be exposed in a conventional manner to a selected pattern of ultraviolet light and developed by removal of unexposed areas of the resist film. That remains is a patterned photoresist layer, or in other words a conductive line mask, which leaves portions of the conductive copper foil layer 18 uncovered while other portions remained covered by the mask. The masked laminate 10 is then treated so as to expose the multiple foil layer 14 to a cupric chloride (CuCl₂)/hydrochloric acid (HCl) etchant which etches the copper foil 18 in those areas which are not covered by the conductive line mask. The etch bath may contain, for example, 200 grams per liter of cupric chloride and 127 ml per liter of concentrated hydrochloric acid. The etch bath may be maintained at a temperature of about 52°C. The result is the removal of the copper foil layer 18 from areas which are not covered by the mask of developed photoresist. The exposed underlying chromium·oxygen·carbon resistive layer may be removed by contacting the exposed portions of the resistive layer of laminate 10 with an 18% (by weight) hydrochloric acid solution at a temperature of 50°C. Preferably the laminate 10 should be immersed in the hydrochloric acid solution for about 10 seconds to complete the removal of the chromium·oxygen·carbon resistive layer 16. The conductive line masking photoresist may then be removed from the copper foil areas to which it had been adhered. A pattern of conductive lines 30, as may best be seen in Figure 3, is left behind. Each of the conductive lines 30 has an outer layer of conductive copper foil 18 and an underlying layer 16 of resistive chromium affixed to the substrate 12.

In order to define one or more planar resistors, a resistive line defining layer of a photoresist may be applied to the pattern of conductive lines illustrated in Figure 3. Again, a photoresist pattern may be defined by exposing the photoresist to a pattern of ultraviolet light and the unexposed portions of photoresist removed, all in a conventional manner. Portions of the resistive line photoresist remain behind to mask the conductive lines 30 or portions thereof which are to remain on the substrate 12. The copper foil layer 18 may then be removed at portions thereof which are not covered by the resistive line mask by immersing the laminate 10 in, or simply contacting the copper foil 18 with the cupric chloride/hydrochloric acid etchant described above. The resistive line mask may then be removed to present the printed circuit board illustrated in Figure 4 and which consists of a resistive line 40 comprised of a portion of the original chromium·oxygen·carbon resistive layer 16, together with means for electrically coupling an electrical potential to the resistive line 40 comprising a pair of conductive copper foil end contact pads 42 and 44 which are in intimate electrical contact with the resistive line 40. As would be well known to one skilled in the printed circuit board art, the pads 42 and 44 provide means for coupling the resistive line 40 to an electrical potential. Moreover, it should be understood that respective pluralities of resistive line planar resistors may be arranged in networks and interconnected by appropriate conductors to provide a variety of resistances and resistance characteristics. The printed circuit board of Figure 4 may also have one or more conductive foil lines 30 remaining thereon to conduct electricity in a conventional manner.

In accordance with the invention the sheet resistances of resistive, chromium layers or lines may be deliberately altered by changing the amount of carbon and/or oxygen electrodeposited therewith simply by varying the electroplating conditions or the chemistry of the plating bath. As set forth above, the source of carbon and oxygen may be an organic, more specifically an aliphatic, acid. Preferably the source may be propionic acid. Several advantages result from the use of a resistive material comprising an electrodeposited layer of a composite of chromium and a resistance increasing amount of a non-metallic additive such as oxygen and/or carbon. A chromium·carbon·oxygen resistive material resists etching by a cupric chloride/hydrochloric acid etchant and such etchant may therefore be utilized to selectively remove copper. This facilitates the control of the etching procedure resulting in an increase in the quality of the end product. Chromium·carbon·oxygen resistive layers also are resistant to corrosion, a property which contributes greatly to product stability during storage, further processing operations and in field applications. Although resistive chromium layers may be etched using a chromic acid etchant, the etching steps do not require the use of chromic acid as a reagent and this reduces environmental problems associated with disposal of chromic acid and chromic acid contaminated materials. In this connection, the chromium resistive materials of the invention are also unetchable by H₂O₂/H₂SO₄, FeCl₃, alkaline ammoniacal and CuCl₂ etchants (which do remove copper) whereby an etchant may be selected to provide an appropriate differential etch rate depending upon the etch characteristics of the particular conductive and resistive layers employed.

In another aspect of the invention of the present application, a resistive layer is provided comprising an electrodeposited layer of a composite of nickel as the normally conductive metal component and a resistance increasing amount of sulfur as the non-metallic additive. A nickel·sulfur resistive layer may thus be produced using a plating bath made up of an aqueous solution containing 100 grams per liter nickel sulfate (NiSO₄ · 6H₂O), 30 grams per liter boric acid (H₃BO₃) and 50 grams per liter sodium thiosulfate (Na₂ S₂O₃ · 5H₂O). Such solution as initially prepared will be moderately acidic such that its pH is in the neighborhood of about 3.2 and the pH may be adjusted before plating by adding a sufficient quantity of sodium hydroxide (NaOH) to bring the pH of the solution to about 6, as measured by a pH meter. The electroplating bath solution may then be heated to a temperature of about 45°C, and while maintained at that temperature, a conductive copper foil layer to be plated upon is connected as the cathode of a beaker electroplating apparatus and is immersed in the plating bath. An electric current having a current density of from about 10 to about 40 amps per square foot is then caused to flow through the plating bath whereupon a nickel·sulfur composite layer plates out on the copper foil.

Alternatively, a plating bath containing 100 grams per liter nickel sulfate, 30 grams per liter boric acid and 10 grams per liter sodium thiosulfate may be employed. Again the pH of the solution should be adjusted to about 6 by the addition of sodium hydroxide and plating may be carried out as set forth above.

In either instance, the current density of the electric current flowing through the plating solution may be varied from about 10 to about 40 amps per square foot and the plating time may be varied from about 30 seconds at a current density of 40 amps per square foot to about 120 seconds at a current density of 10 amps per square foot.

After the nickel·sulfur layer has been formed on the copper foil substrate, the multiple layer foil is removed from the plating bath. As an optional step, after the multiple layer resistive foil is removed from the plating bath, the same may be immersed in a solution of chromic acid (CrO₃) at a concentration of about 2 grams per liter to stabilize the multiple layer resistive foil.

The nickel·sulfur composite layer formed on a conductive copper foil in the above described bath and using the above described plating times and current densities will possess a sheet resistance of about 25 Ω per square. The nickel resistive layers thus formed are very stable, and even after exposure to air for extended periods of time, the sheet resistance values have been found to vary on the average by less than about 2%.

The multiple layer foil produced by electrodepositing a nickel·sulfur resistive layer on a copper conductive layer may be utilized to prepare a laminate for subsequent use in preparing a printed circuit board. With reference to Figures 1 and 2, the layer 16 is in this case simply a nickel·sulfur layer rather than the chromium·carbon·oxygen layer described above. In all other respects the laminate 10 may be essentially the same as has been described above. Thus, the laminate 10 is made up of a multiple layer foil 14 which comprises an electrodeposited resistive nickel layer 16 bonded or laminated to the substrate 12 and a conductive copper foil layer 18 suitable for preparing printed circuits. And in a preferred commercial sense, prior to use as the cathodic substrate in the plating bath, the conductive copper foil 18 should preferably have been stabilized so as to improve its resistance to oxidation.

The laminate 10, which includes a nickel·sulfur resistive layer 16, may be produced by applying temperature and pressure as set forth above. The resultant laminate may be subjected to etching to prepare a printed circuit board. A photoresist may be applied as described above and exposed to a selected pattern of ultraviolet light. What remains after suitable development is a patterned photoresist layer or conductive line mask which covers portions of the conductive copper foil layer 18 and leaves other portions uncovered. The multiple foil layer 14 of the laminate 10 may then be exposed to a cupric chloride/hydrochloric acid etchant as described above. The etch bath may contain 200 grams per liter of cupric chloride and 127 ml per liter of concentrated hydrochloric acid. During etching the etch bath may preferably be maintained at a temperature of about 52°C. Such an etch bath removes the copper foil 18 and the nickel·sulfur layer 16 at those areas which are not covered by the photoresist mask.

When the laminate is processed as set forth above, an unidentified residue may remain on the substrate 12. This residue may be removed using a residue stripping etchant made up of 300 grams per liter of chromic acid and 30 ml per liter of concentrated sulfuric acid. This bath may be maintained at a temperature 45°C and the stripping should be achieved in about 15 seconds. The remaining photoresist is then removed from the copper foil 18 and a pattern of conductive lines 30 as illustrated in Figure 3 remains. Each of the conductive lines 30 has an outer layer of the conductive copper foil 18 and an underlying layer of the resistive nickel layer 16 affixed to the substrate 12.

In order to define one or more planar resistors, a resistive line defining layer of a photopolymer film resist may be applied to the multiple layer printed laminate or circuit board 10. A second photoresist pattern may be defined by exposing the photoresist to an ultraviolet light pattern and the photoresist may then be suitably developed. Undeveloped portions of the resistive line photoresist are removed and the remaining portions present a resistive line mask covering the conductive lines 30 or portions thereof which are to remain on the substrate 12. Other portions of the conductive lines 30 are not covered by the resistive line mask. The exposed portions of the copper foil layer 18 of the lines 30 may then be removed by contacting the copper layer 18 with a preferential etchant comprised of an aqueous solution containing 300 grams per liter of chromic acid and 30 ml per liter of concentrated sulfuric acid. At a temperature of 45°C, the chromic acid/sulfuric acid preferential etchant generally will not attack the resistive nickel·sulfur layer 16.

Upon removal of the resistive line mask, a printed circuit board is presented which has a resistive line 40 comprised of the nickel·sulfur composite and means for electrically coupling a potential to the nickel·sulfur resistive line 40 comprising a pair of conductive copper foil end contact pads 42 and 44 which are in intimate electrical connection with the resistive line, as can best be seen in Figure 4. The printed circuit board may also have one or more of the conductive foil lines 30 remaining thereon to conduct electricity in a conventional fashion and/or a plurality of resistive lines 40 arranged in an appropriate network.

In preparing the nickel·sulfur resistive material of the invention, a bath is used which comprises nickel sulfate as a source of the normally conductive metal nickel, sodium thiosulfate as a source of a non-metallic resistance increasing additive and boric acid as a pH buffering agent. The concentration of each of the materials may be altered to provide different effects. Higher concentrations of nickel sulfate in the bath generally result in higher concentrations of nickel in the electrodeposited resistive layers to thereby increase the conductivity and as a result decrease the sheet resistance of the electrodeposited layer. Higher levels of nickel sulfate, however, generally result in greater chemical loss during the electroplating process due to drag out. Higher concentrations of sodium thiosulfate will generally produce higher levels of sulfur in the electrodeposited resistive layer to thereby, at least in a general sense, increase the sheet resistance of the electrodeposited layer.

In preparing the nickel·sulfur resistive layers the current density and plating time may be varied to obtain different results. Since, at least in a general sense, the cross-sectional area of the nickel·sulfur layer determines the sheet resistance, different thicknesses of the layer will provide different resistances. By passing a certain amount of coulombic charge through the solution, a certain definite thickness of material is deposited.

The current density may be varied from about 10 to about 40 amps per square foot and the plating time may be varied from about 30 to about 120 seconds for each current density. Within these ranges the thickness of the electrodeposited resistance layer increases linearly with increased plating time and sheet resistance thus decreases with increased plating time. Nickel·sulfur resistance layers in accordance with the invention electroplated upon a conductive copper foil substrate using 1200 coulombs of electrical charge will have thicknesses of about 0.4 µ and sheet resistances of about 25 Ω per square.

In accordance with the invention, impurities and defects in the crystal lattice of an electrodeposited material are usually considered to have the effect of decreasing the conductivity from that of a pure bulk material. The resistive chromium and nickel layers electrodeposited upon copper substrates, or any other substrates for that matter, have an intrinsically smaller conductivity (or greater sheet resistance) than corresponding metallic chromium and nickel layers would have. The higher sheet resistances of the chromium and nickel containing resistive layers is believed to arise from the inclusion of the carbon, oxygen and sulfur impurities into the metallic deposit. The intrinsically greater sheet resistance allows the layer to be applied over the entire surface of the conductor, without the necessity for using mechanical or chemical means for thinning or removing the layers in selected areas to thereby decrease the effective cross-sectional area of the layers to achieve the desired sheet resistance at localized positions. Rather, the desired sheet resistance may be achieved simply by varying the chemical content of the electroplating bath and/or the electroplating conditions.

The resistive layers of the invention are utilized in such a manner as to entirely cover the conductor surface. Moreover, after the resistive layer has been laminated to a dielectric substrate and the copper removed in the desired areas, the resistor layer completely covers the dielectric substrate. When the resistor has been defined correctly by using proper masking design and art work, post-processing of the resistive material by mechanical and/or chemical means is not required to achieve the desired resistance.

The thickness of the layer 16, for example, whether it be a chromium·oxygen·carbon composite or a nickel·sulfur composite, may be varied to achieve the commercially required dimensions of the planar resistor and sheet resistance thereof. The thickness of the conductive layer 18 does not effect the resistance of the resistor. Typically a layer 16 produced in accordance with the invention to achieve a sheet resistance of 25 Ω/square will have a thickness in the range of from about 0.1 to about 0.4 µ.

In accordance with the invention, the targeted sheet resistance range is from about 15 to about 1000 Ω per square. Functional resistors can be made with any sheet resistance in this range by controlling the geometry of the etched resistor, i.e., by varying the length and the width of the etched resistor on the circuit board. Inside this resistance range, a sheet resistance value of about 25 Ω per square is preferred for simplification of production processes. Thus, by controlling the plating time, almost any of the above described plating bath conditions, such as concentration of bath ingredients and temperatures, may be employed to produce resistors having a sheet resistance of about 25 Ω per square.

Combined with proper physical and topographical design, sheet resistances of 25, 100 and 1000 Ω/square can be achieved in accordance with the present invention and conveniently employed to make planar resistors having resistances in the commercially desirable range of from 1 Ω to 1 Mega Ω.

For ease of reference preferred features and embodiments of the invention will now be described in the following numbered paragraphs (hereinafter para.)
1. A resistive layer for use in preparing printed circuit boards comprising an electrodeposited composite of a normally conductive metal component and a resistance increasing amount of a non-metallic additive comprising at least one of carbon, oxygen and sulfur.
2. A resistive layer as set forth in para. 1, wherein said metal component comprises nickel.
3. A resistive layer as set forth in para. 1, wherein said non-metallic additive comprises sulfur.
4. A resistive layer as set forth in para. 2, wherein said non-metallic additive comprises sulfur.
5. A resistive layer as set forth in para. 4, wherein said layer has a sheet resistance in the range of from about 15 to about 1000 Ω per square.
6. A resistive layer as set forth in para. 1, wherein said metal component comprises chromium.
7. A resistive layer as set forth in para. 1, wherein said non-metallic additive comprises oxygen.
8. A resistive layer as set forth in para. 1, wherein said non-metallic additive comprises carbon.
9. A resistive layer as set forth in para. 1, wherein said non-metallic additive comprises oxygen and carbon.
10. A resistive layer as set forth in para. 6, wherein said non-metallic additive comprises oxygen and carbon.
11. A resistive layer as set forth in para. 10, wherein said layer has a sheet resistance in the range of from about 15 to about 1000 Ω per square.
12. A multiple layer foil for use in preparing printed circuit boards and comprising a conductive foil layer and a resistive layer as set forth in claim 1 electrodeposited thereon.
13. A multiple layer foil as set forth in para. 12, wherein said conductive foil layer comprises copper.
14. A multiple layer foil as set forth in para. 12, wherein said metal component comprises nickel.
15. A multiple layer foil as set forth in para. 12, wherein said non-metallic additive comprises sulfur.
16. A multiple layer foil as set forth in para. 14, wherein said non-metallic additive comprises sulfur.
17. A multiple layer foil as set forth in para. 16, wherein said resistive layer has a sheet resistance in the range of from about 15 to about 1000 Ω per square.
18. A multiple layer foil as set forth in para. 12, wherein said metal component comprises chromium.
19. A multiple layer foil as set forth in para. 12, wherein said non-metallic additive comprises oxygen.
20. A multiple layer foil as set forth in para. 12, wherein said non-metallic additive comprises carbon.
21. A multiple layer foil as set forth in para. 12, wherein said non-metallic additive comprises oxygen and carbon.
22. A multiple layer foil as set forth in para. 18, wherein said non-metallic additive comprises oxygen and carbon.
23. A multiple layer foil as set forth in para. 22, wherein said resistive layer has a sheet resistance in the range from about 15 to about 1000 Ω per square.
24. A multiple layer foil as set forth in para. 13, wherein said copper conductive layer is an electrodeposited layer.
25. A multiple layer foil as set forth in para. 24, wherein said metal component comprises nickel.
26. A multiple layer foil as set forth in para. 24, wherein said non-metallic additive comprises sulfur.
27. A multiple layer foil as set forth in para. 25, wherein said non-metallic additive comprises sulfur.
28. A multiple layer foil as set forth in para. 27, wherein said resistive layer has a sheet resistance in the range from about 15 to about 1000 Ω per square.
29. A multiple layer foil as set forth in para. 24, wherein said metal component comprises chromium.
30. A multiple layer foil as set forth in para. 24, wherein said non-metallic additive comprises oxygen.
31. A multiple layer foil as set forth in para. 24, wherein said non-metallic additive comprises carbon.
32. A multiple layer foil as set forth in para. 24, wherein said non-metallic additive comprises oxygen and carbon.
33. A multiple layer foil as set forth in para. 29, wherein said non-metallic additive comprises oxygen and carbon.
34. A multiple layer foil as set forth in para. 33, wherein said resistive layer has a sheet resistance in the range of from about 15 to about 1000 Ω per square.
35. A laminate for preparing printed circuit boards and comprising an insulative layer and a resistive layer as set forth in claim 1 adhered thereto.
36. A laminate as set forth in para. 35 and a conductive foil layer adhered to said resistive layer.
37. A laminate as set forth in para. 36, wherein said conductive layer comprises copper.
38. A laminate as set forth in para. 35, wherein said metal component comprises nickel.
39. A laminate as set forth in para. 35, wherein said non-metallic additive comprises sulfur.
40. A laminate as set forth in para. 38, wherein said non-metallic additive comprises sulfur.
41. A laminate as set forth in para. 40, wherein said resistive layer has a sheet resistance in the range of from about 15 to about 1000 Ω per square.
42. A laminate as set forth in para. 35, wherein said metal component comprises chromium.
43. A laminate as set forth in para. 35, wherein said non-metallic additive comprises oxygen.
44. A laminate as set forth in para. 35, wherein said non-metallic additive comprises carbon.
45. A laminate as set forth in para. 35, wherein said non-metallic additive comprises oxygen and carbon.
46. A laminate as set forth in para. 42, wherein said non-metallic additive comprises oxygen and carbon.
47. A laminate as set forth in para. 46, wherein said resistive layer has a sheet resistance in the range of from about 15 to about 1000 Ω per square.
48. A laminate as set forth in para. 37, wherein said metal component comprises nickel.
49. A laminate as set forth in para. 37, wherein said non-metallic additive comprises sulfur.
50. A laminate as set forth in para. 48, wherein said non-metallic additive comprises sulfur.
51. A laminate as set forth in para. 50, wherein said resistive layer has a sheet resistance in the range of from about 15 to about 1000 Ω per square.
52. A laminate as set forth in para. 37, wherein said metal component comprises chromium.
53. A laminate as set forth in para. 37, wherein said non-metallic additive comprises oxygen.
54. A laminate as set forth in para. 37, wherein said non-metallic additive comprises carbon.
55. A laminate as set forth in para. 37, wherein said non-metallic additive comprises oxygen and carbon.
56. A laminate as set forth in para. 52, wherein said non-metallic additive comprises oxygen and carbon.
57. A laminate as set forth in para. 56, wherein said resistive layer has a sheet resistance in the range of from about 15 to about 1000 Ω per square.
58. A printed circuit board comprising an insulative layer and a resistive line bonded to the insulative layer, said resistive line being composed of an electrodeposited material comprising a composite of a normally conductive metal component and a resistance increasing amount of a non-metallic additive comprising at least one of carbon, oxygen and sulfur.
59. A printed circuit board as set forth in para. 58, wherein said resistive line has a sheet resistance in the range of from about 15 to about 1000 Ω per square.
60. A printed circuit board as set forth ir para. 58, wherein said metal component comprises nickel.
61. A printed circuit board as set forth in para. 58, wherein said non-metallic additive comprises sulfur.
62. A printed circuit board as set forth in para. 60, wherein said non-metallic additive comprises sulfur.
63. A printed circuit board as set forth in para. 62, wherein said resistive line has a sheet resistance in the range of from about 15 to about 1000 Ω per square.
64. A printed circuit board as set forth in para. 58, wherein said metal component comprises chromium.
65. A printed circuit board as set forth in para. 58, wherein said non-metallic additive comprises oxygen.
66. A printed circuit board as set forth in para. 58, wherein said non-metallic additive comprises carbon.
67. A printed circuit board as set forth in para. 58, wherein said non-metallic additive comprises oxygen and carbon.
68. A printed circuit board as set forth in para. 64, wherein said non-metallic additive comprises oxygen and carbon.
69. A printed circuit board as set forth in para. 68, wherein said resistive line has a sheet resistance in the range of from about 15 to about 1000 Ω per square.
70. A printed circuit board as set forth in para. 63, and means for electrically coupling an electrical potential to said resistive line.
71. A printed circuit board as set forth in para. 70, wherein said electrically coupling means comprises a pair of spaced copper pads adhered to said resistive line.
72. A printed circuit board as set forth in para. 69, and means for electrically coupling an electrical potential to said resistive line.
73. A printed circuit board as set forth in para. 72, wherein said electrically coupling means comprises a pair of spaced copper pads adhered to said resistive line.
74. A printed circuit board as set forth in para. 59, and means for electrically coupling an electrical potential to said resistive line.
75. A printed circuit board as set forth in para. 74, wherein said electrically coupling means comprises a pair of spaced copper pads adhered to said resistive line.
76. A printed circuit board as set forth in para. 71, wherein said line and said pads are characterized by having been created by etching respective electrodeposited layers.
77. A printed circuit board as set forth in para. 73, wherein said line and said pads are characterized by having been created by etching respective electrodeposited layers.
78. A printed circuit board as set forth in para. 75, wherein said line and said pads are characterized by having been created by etching respective electrodeposited layers.
79. A method of electrodepositing a resistive layer comprising the steps of:
   providing a plating bath comprising an aqueous solution of a first source of a normally conductive metal component and a second source of a non-metallic resistance increasing additive comprising one or more of oxygen, carbon and sulfur;
   placing a conductive member in said bath; and
   electroplating a layer comprising a composite of said metal component and said additive on said conductive member by passing an electric current through the bath using said conductive member as a cathode.
80. A method as set forth in para. 79, wherein said first source is a source of chromium.
81. A method as set forth in para. 79, wherein said first source is a source of nickel.
82. A method as set forth in para. 79, wherein said second source is a source of sulfur.
83. A method as set forth in para. 81, wherein said second source is a source of sulfur.
84. A method as set forth in para. 79, wherein said second source is a source of oxygen.
85. A method as set forth in para. 79, wherein said second source is a source of carbon.
86. A method as set forth in para. 80, wherein said second source is a source of oxygen and carbon.
87. A method as set forth in para. 86, wherein said second source comprises a water soluble organic acid or ionizable salt thereof.
88. A method as set forth in para. 87, wherein said second source comprises formic acid, acetic acid, propionic acid or an alkali metal salt of such an acid.
89. A method as set forth in para. 88, wherein said second source comprises propionic acid.
90. A method as set forth in para. 79, wherein a catalyst is provided in said bath.
91. A method as set forth in para. 87, wherein a catalyst is provided in said bath.
92. A method as set forth in para. 91, wherein said catalyst comprises oxy-halo anions.
93. A method as set forth in para. 91, wherein said catalyst comprises anions of a water soluble, ionizable oxidizing compound, which anions are incapable of contributing a metallic compound to the deposit.
94. A method as set forth in para. 93, wherein said anions are oxy-halo anions.
95. A method as set forth in para. 94, wherein said anions are periodate, iodate, perbromate, bromate, perchlorate or chlorate ions.
96. A method as set forth in para. 95, wherein said anions are chlorate ions.
97. A method as set forth in para. 91, wherein said catalyst comprises sulphate ions.
98. A method as set forth in para. 92, wherein said catalyst comprises sulphate ions.
99. A method as set forth in para. 90, wherein said first source comprises CrO₃, said second source comprises propionic acid and said catalyst comprises an alkali metal chlorate salt.
100. A method as set forth in para. 99, wherein said bath further comprises sulfate ions.
101. A method as set forth in para. 83, wherein said first source comprises NiSO₄ and said second source comprises Na₂ S₂O₃.
102. A method as set forth in para. 101, wherein said bath further comprises boric acid.
103. A plating bath for electrodepositing a resistive layer comprising an aqueous solution of a first source of a normally conductive metal component and a second source of a non-metallic resistance increasing additive comprising one or more of oxygen, carbon and sulfur.
104. A plating bath as set forth in para. 103, wherein said first source is a source of chromium.
105. A plating bath as set forth in para. 103, wherein said first source is a source of nickel.
106. A plating bath as set forth in para. 103, wherein said second source is a source of sulfur.
107. A plating bath as set forth in para. 105, wherein said second source is a source of sulfur.
108. A plating bath as set forth in para. 103, wherein said second source is a source of oxygen.
109. A plating bath as set forth in para. 103, wherein said second source is a source of carbon.
110. A plating bath as set forth in para. 104, wherein said second source is a source of oxygen and carbon.
111. A plating bath as set forth in para. 110, wherein said second source comprises a water soluble organic acid or ionizable salt thereof.
112. A plating bath as set forth in para. 111, wherein said second source comprises formic acid, acetic acid, propionic acid or an alkali metal salt of such an acid.
113. A plating bath as set forth in para. 112, wherein said second source comprises propionic acid.
114. A plating bath as set forth in para. 103, wherein a catalyst is provided in said bath.
115. A plating bath as set forth in para. 111, wherein a catalyst is provided in said bath.
116. A plating bath as set forth in para. 115, wherein said catalyst comprises oxy-halo anions.
117. A plating bath as set forth in para. 115, wherein said catalyst comprises anions of a water soluble, ionizable oxidizing compound, which anions are incapable of contributing a metallic compound to the deposit.
118. A plating bath as set forth in para. 117, wherein said anions are oxy-halo anions.
119. A plating bath as set forth in para. 118, wherein said anions are periodate, iodate, perbromate, bromate, perchlorate or chlorate ions.
120. A plating bath as set forth in para. 119, wherein said anions are a chlorate ions.
121. A plating bath as set forth in para. 115, wherein said catalyst comprises sulphate ions.
122. A plating bath as set forth in para. 116, wherein said catalyst comprises sulphate ions.
123. A plating bath as set forth in para. 114, wherein said first source comprises CrO₃, said second source comprises propionic acid and said catalyst comprises an alkali metal chlorate salt.
124. A plating bath as set forth in para. 123, wherein said bath further comprises sulfate ions.
125. A plating bath as set forth in para. 107, wherein said first source comprises NiSO₄ and said second source comprises Na₂ S₂O₃.
126. A plating bath as set forth in para. 125, wherein said bath further comprises boric acid.
127. A method for preparing a printed circuit board having at least one resistive line and a conductive area on an insulative layer, said method comprising the steps of:
   providing a laminate having an insulative layer, a resistive chromium layer bonded to the insulative layer and conductive copper foil layer affixed to the resistive chromium layer;
   masking the laminate with a first mask;
   contacting the laminate having the first mask thereon with a first etchant comprising cupric chloride to remove the conductive copper foil layer from all portions of the resistive chromium layer not covered by the first mask;
   contacting the laminate with a second etchant comprising hydrochloric acid to remove the resistive chromium layer from all portions of the insulative layer not covered by the first mask;
   removing the first mask from the laminate;
   masking the laminate with a second mask; and
   contacting the laminate having the second mask thereon with a third etchant comprising cupric chloride to remove the conductive copper foil layer from all portions of the laminate not covered by the second mask while leaving behind the remaining resistive chromium layer to define a resistive chromium line on the insulative layer and a conductive copper area on a portion of the resistive chromium line.
128. A method of preparing a printed circuit board as set forth in para. 127, wherein the second etchant is 18% (by wt) hydrochloric acid.
129. A method of preparing a printed circuit board as set forth in para. 128, wherein said concentrated hydrochloric acid is maintained at a temperature of about 50°C.
130. A method of preparing a printed circuit board as set forth in para. 129, wherein the step of contacting the laminate with the second etchant to remove unnasked portions of the resistive chromium layer has a duration of about 10 seconds.
131. A method of preparing a printed circuit board having at least one resistive line and a conductive area on an insulative layer, said method comprising the steps of:
   providing a laminate having an insulative layer, a resistive nickel and sulfur layer bonded to the insulative layer and a conductive copper foil layer affixed to the resistive nickel and sulfur layer;
   masking the laminate with a first mask;
   contacting the laminate having the first mask thereon with a first etchant comprising cupric chloride to remove the conductive copper foil layer and the resistive nickel and sulfur layer from all portions of the insulative layer not covered by the first mask;
   contacting the laminate having the first mask thereon with a second etchant comprising chromic acid and sulfuric acid to remove residue from all unmasked portions of the insulative layer;
   removing the first mask from the laminate;
   masking the laminate with a second mask;
   contacting the laminate having the second mask thereon with a third etchant comprising chromic acid and sulfuric acid to remove the conductive copper foil layer from all unmasked portions of the laminate while leaving behind the remaining resistive nickel and sulfur layer to define a resistive nickel and sulfur line on the insulative layer and a conductive copper area on a portion of the resistive nickel and sulfur line.
132. A method of preparing a circuit board as set forth in para. 131, further comprising the step of maintaining the second etchant at a temperature not greater than 50°C.
133. A method of preparing a printed circuit board as set forth in para. 131, wherein the step of contacting the laminate with the second etchant to remove the residue from unmasked portions of the insulative layer has a duration of about 15 seconds.
134. A resistive layer as set forth in para. 1, wherein said layer has a sheet resistance in the range of from about 15 to about 1000 Ω per square.
135. A multiple layer foil as set forth in para. 12, wherein maid resistive layer has a sheet resistance in the range of from about 15 to about 1000 Ω per square.
136. A laminate as set forth in para. 35, wherein said resistive layer has a sheet resistance in the range of from about 15 to about 1000 Ω per square.

## Claims

1. A resistive layer for use in preparing at least one of printed circuit boards and laminates comprising an electrodeposited composite of a normally conductive metal component comprising chromium and a resistance increasing amount of a non-metallic additive comprising at least one of carbon, oxygen and sulfur.

2. A resistive layer as set forth in claim 1, wherein said layer has a sheet resistance in the range of from about 15 to about 1000 Ω per square.

3. A multiple layer foil for use in preparing printed circuit boards and comprising a conductive foil layer and a resistive layer as set forth in claim 1 or claim 2 electrodeposited thereon.

4. A multiple layer foil as set forth in claim 3, wherein said conductive foil layer comprises copper.

5. A multiple layer foil as set forth in claim 4, wherein said copper conductive layer is an electrodeposited layer.

6. A laminate for preparing printed circuit boards and comprising an insulative layer and a resistive layer as set forth in claim 1 or claim 2 adhered thereto.

7. A laminate as set forth in claim 6 and a conductive foil layer adhered to said resistive layer.

8. A laminate as set forth in claim 7, wherein said conductive layer comprises copper.

9. A printed circuit board comprising an insulative layer and a resistive line bonded to the insulative layer, said resistive line being composed of an electrodeposited material comprising a composite of a normally conductive metal component comprising chromium and a resistance increasing amount of a non-metallic additive comprising at least one of carbon, oxygen and sulfur.

10. A printed circuit board as set forth in claim 9, wherein said resistive line has a sheet resistance in the range of from about 15 to about 1000 Ω per square.

11. A printed circuit board as set forth in claim 10, and means for electrically coupling an electrical potential to said resistive line.

12. A printed circuit board as set forth in claim 11, wherein said electrically coupling means comprises a pair of spaced copper pads adhered to said resistive line.

13. A printed circuit board as set forth in claim 12, wherein said line and said pads are characterized by having been created by etching respective electrodeposited layers.

14. A method of electrodepositing a resistive layer comprising the steps of:
providing a plating bath comprising an aqueous solution of a first source of a normally conductive metal component comprising chromium and a second source of a non-metallic resistance increasing additive comprising one or more of oxygen, carbon and sulfur;
placing a conductive member in said bath; and
electroplating a layer comprising a composite of said metal component and said additive on said conductive member by passing an electric current through the bath using said conductive member as a cathode.

15. A method as set forth in claim 14, wherein a catalyst is provided in said bath.

16. A method as set forth in claim 15, wherein said first source comprises CrO₃, said second source comprises propionic acid and said catalyst comprises an alkali metal chlorate salt.

17. A plating bath for electrodepositing a resistive layer comprising an aqueous solution of a first source of a normally conductive metal component comprising chromium and a second source of non-metallic resistance increasing additive comprising one or more of oxygen, carbon and sulfur.

18. A plating bath as set forth in claim 17, wherein a catalyst is provided in said bath.

19. A plating bath as set forth in claim 18, wherein said first source comprises CrO₃, said second source comprises propionic acid and said catalyst comprises an alkali metal chlorate salt.
